# EUROPÄISCHE PATENTSCHRIFT

(11) **EP 2 150 633 B1**
(45) Veröffentlichungstag und Bekanntmachung des Hinweises auf die Patenterteilung: **17.09.2014**
(21) Anmeldenummer: 08758126.0
(22) Anmeldetag: 28.05.2008
(51) Int. Cl.: C23C 16/40, C23C 16/453, C23C 16/513, C03C 17/00, C03C 17/245

(54) **VERFAHREN ZUM BESCHICHTEN EINES SUBSTRATS**
METHOD FOR COATING A SUBSTRATE
PROCÉDÉ DE REVÊTEMENT D'UN SUBSTRAT

(30) Priorität: 29.05.2007 DE 102007025152
(43) Veröffentlichungstag der Anmeldung: 10.02.2010
(73) Patentinhaber: Innovent e.V., 07745 Jena (DE)
(72) Erfinder: HEFT, Andreas, 07545 Gera (DE); PFUCH, Andreas, 99510 Apolda (DE); SCHIMANSKI, Arnd, 44329 Dortmund (DE); GRÜNLER, Bernd, 07937 Zeulenroda (DE); POLSTER, Martin, 07952 Pausa (DE)
(74) Vertreter: Liedtke, Markus
(86) Internationale Anmeldenummer: PCT/DE2008/000886
(87) Internationale Veröffentlichungsnummer: WO 2008/145102

(56) Entgegenhaltungen:
- EP-A- 1 394 283
- FR-A- 2 887 872
- US-A- 3 674 453
- HOPFE V ET AL: "LINEAR EXTENDED ARCJET-CVS - A NEW PECVD APPROACH FOR CONTINUOUS WIDE AREA COATING UNDER ATMOSPHERIC PRESSURE" CHEMICAL VAPOR DEPOSITION, WILEY-VCH VERLAG, WEINHEIM, DE, Bd. 11, 1. Januar 2005 (2005-01-01), Seiten 510-522, XP001501983 ISSN: 0948-1907

## Beschreibung

Die Erfindung betrifft ein Verfahren zum Beschichten eines Substrats.

Um die Oberflächeneigenschaften verschiedener Substrate zu beeinflussen, sind seit geraumer Zeit Beschichtungsverfahren gebräuchlich, bei denen Beschichtungsstoffe aus einer Gasphase auf einer Oberfläche abgeschieden werden. Dabei wird unter anderem zwischen chemischen und physikalischen Gasphasenabscheidungen unterschieden. Bei den chemischen Verfahren werden meist so genannte Precursoren, Vorläuferstoffe der Beschichtungsstoffe, mittels Energiezuführung umgesetzt, Reaktionsprodukte der Precursoren auf die Oberfläche geleitet und dort abgelagert. Die Energiezuführung kann beispielsweise mittels Beflammung erfolgen. Der der Flamme zugeführte Precursor bildet bei seiner thermischen Umsetzung Partikel, insbesondere Nanopartikel, die noch in der Flamme agglomerieren und sich dann an der Oberfläche absetzen. Auf diese Weise ist eine homogene und dichte Beschichtung möglich, jedoch unter hohem Energieeinsatz. Eine andere Möglichkeit bieten so genannte Niederdruckplasmaverfahren, bei denen der Precursor in einer Plasmaquelle oder in deren räumlicher Nähe auf den zu beschichtenden Oberflächen zu Dünnschichten umgesetzt wird. Dieses energetisch vorteilhafte Verfahren benötigt allerdings evakuierte Prozesskammern und ist daher aufwändig und unflexibel.

Seit einigen Jahren sind so genannte Normaldruckplasmaverfahren bekannt, bei denen die zu beschichtenden Oberflächen nicht in ein Vakuum eingebracht werden müssen. Die Partikelbildung erfolgt hierbei schon im Plasma. Die Größe der dabei entstehenden Agglomerate und somit wesentliche Eigenschaften der Beschichtung lassen sich unter anderem durch den Abstand der Plasmaquelle von der Oberfläche einstellen. Die Homogenität der abgeschiedenen Schichten ist, eine geeignete Führung des Substrats vorausgesetzt, mit den durch Beflammung erzielten vergleichbar, der erforderliche Energieeintrag ist jedoch wesentlich geringer.

Aus der FR 2 887 872 ist ein Verfahren zur Herstellung eines Glasprodukts bekannt, dessen größte Dimension größer als 1 m ist. Das Verfahren umfasst mindestens:
- in einer ersten Vorrichtung einen Herstellungs- oder Transformationsschritt eines Glassubstrats, dessen Dimension im rechten Winkel zu einer Vorschubrichtung entlang der Vorrichtung im Wesentlichen größer als 1 m, vorzugsweise größer als 1,5 m, insbesondere bis 2 m ist, wobei das Substrat bei einer Temperatur zwischen 50 °C und 750 °C entlang der Vorrichtung gefahren wird,
- einen Schritt der Modifikation der Oberfläche des Glassubstrats durch eine Atmosphärendruck-Plasmavorrichtung, wobei dieser Schritt der Modifikation der Oberfläche vor, während oder nach dem Herstellungs- oder Transformationsschritt auf dem heißen Substrat durchgeführt wird.

In der EP 1 394 283 A1 sind ein Verfahren und eine Vorrichtung zur großflächigen Beschichtung von Substraten bei Atmosphärendruckbedingungen offenbart, wobei unter letzterem ein Druckintervall von ± 300 Pa um den jeweiligen Umgebungsatmosphärendruck verstanden werden soll. Mit der erfindungsgemäßen Lösung sollen Beschichtungen bei Atmosphärendruckbedingungen auf großen Flächen, bei gleichzeitiger Vermeidung der unerwünschten Partikelbildung erhalten werden können. Zur Lösung dieser Aufgabe wird in eine Plasmaquelle ein erster Gasstrom geführt, der Plasma aus einem großvolumigen Plasma aus der Plasmaquelle austreibt und das erzeugte Plasma durch mindestens eine Schlitzdüse oder eine Mehrzahl von Düsen auf eine zu beschichtende Oberfläche des Substrates, die innerhalb einer abgedichteten Reaktionskammer angeordnet ist, richtet. Die Schichtausbildung erfolgt unmittelbar auf der Oberfläche des Substrates durch physikochemische Reaktion mindestens einer Komponente eines Precursors. Der Precursor ist Bestandteil mindestens eines zweiten Gasstromes, der in die Reaktionskammer und in den Einflussbereich des aus der Plasmaquelle austretenden Plasmas gerichtet wird. Weiter wird durch Einstellung der Volumenströme, der Strömungsgeschwindigkeiten und/oder der Strömungsrichtungen des Plasmas und des zweiten Gasstromes sowie des Abstandes von Düsenöffnungen für das Plasma und eines vorgebbaren Innendrucks in der Reaktionskammer gesichert, dass die physikochemische Reaktion zur Ausbildung der Beschichtung unmittelbar an der Oberfläche des Substrates erfolgt.

Der Erfindung liegt die Aufgabe zu Grunde, ein den Stand der Technik bereicherndes Verfahren zur Beschichtung eines Substrates anzugeben.

Die Aufgabe wird erfindungsgemäß gelöst durch ein Verfahren mit den Merkmalen des Anspruchs 1.

Vorteilhafte Ausgestaltungen der Erfindung sind Gegenstand der Unteransprüche.

Bei einem erfindungsgemäßen Verfahren zum Beschichten eines Substrats, insbesondere aus Glas, wird aus einem Arbeitsgas ein Plasmastrahl erzeugt. Dem Arbeitsgas und/oder dem Plasmastrahl wird mindestens ein Precursormaterial zugeführt und im Plasmastrahl zur Reaktion gebracht. Mindestens ein Reaktionsprodukt mindestens eines der Precursoren wird auf mindestens einer Oberfläche des Substrats und/oder auf mindestens einer auf der Oberfläche angeordneten Schicht abgeschieden. Dabei dient mindestens eine der abgeschiedenen Schichten einer Transmissionsverbesserung der Oberfläche. Das bedeutet, dass die Reflexion an der Oberfläche vermindert wird, so dass mehr Licht in die Oberfläche einfällt und das Substrat passieren kann. Erfindungsgemäß findet zumindest ein erster solcher Beschichtungsvorgang auf einer heißen oder erhitzten Oberfläche des Substrats statt. Die erste Beschichtung findet im Anschluss an einen Herstellungsprozess des Substrats statt, bei dem das Substrat mit Hilfe von Wärme gebildet wird.

Insbesondere bei Beschichtung von Glas kann der Beschichtungsvorgang unmittelbar im Anschluss an einen Herstellungsprozess des Glases stattfinden, wenn das Glas im noch heißen Zustand eine Floatwanne verlässt. Die Haftung einer so aufgebrachten Schicht ist besonders gut, da eine frische Glasoberfläche besonders reaktiv ist. Glasoberflächen nehmen relativ schnell Wasser, Kohlendioxid und andere Substanzen aus der Atmosphäre auf und verlieren dabei einen beträchtlichen Teil ihrer Reaktivität. Die Beschichtung heißen Glases mittels eines Plasmaverfahrens ist im Vergleich mit einer Beflammung vorteilhaft, da das Plasma die heiße Glasoberfläche anders als eine Flamme oder deren Verbrennungsgase nicht zusätzlich erwärmt und so eine Verformung, beispielsweise eine Wellenbildung, vermieden wird. Zudem ist der Energieaufwand wesentlich geringer als für eine Beflammung, so dass Kosten reduziert werden. Verglichen mit dem einfachen Aufsprühen einer Beschichtungslösung oder der Ablagerung von Partikeln aus einem Gasstrom, bei denen die für die Reaktion zur Bildung der Schicht erforderliche Energie aus der Wärme des Glases entnommen wird und so, zusammen mit Konvektion, zu einer unerwünscht raschen Abkühlung des Glases führt, ist das erfindungsgemäße Verfahren dadurch gekennzeichnet, dass bei einem Plasmabeschichtungsverfahren das Plasma einerseits die Reaktionsenergie liefert und andererseits die Oberfläche nicht zusätzlich aufheizt. Ein Ausschluss von Luft und Wasserdampf bzw. Reaktionsprodukten daraus sind bei einem Plasmabeschichtungsverfahren im Gegensatz zu einer Beflammung problemlos möglich, beispielsweise durch geeignete Wahl des Arbeitsgases. Auf diese Weise können beispielsweise Luft oder Sauerstoff aus den zu bildenden Schichten und von der Oberfläche ferngehalten werden. Im Gegensatz zu einer Beflammung wird bei einem Plasmabeschichtungsverfahren auf einem Glassubstrat im Anschluss an einen Herstellungsprozess des Glases in der Floatwanne die Abscheidung der aus dem Precursor gebildeten Beschichtungssubstanzen nicht durch die Thermik des heißen Glases gestört. Das beschriebene Verfahren ist auch auf einem bereits mit mindestens einer Schicht versehenen Substrat anwendbar.

In gleicher oder ähnlicher Weise lassen sich auch andere Substrate, beispielsweise aus Kunststoff, insbesondere transparentem Kunststoff beschichten.

Insbesondere bei Beschichtung eines Substrats aus Glas liegt die Temperatur der zu beschichtenden Oberfläche in einem Bereich von 100°C bis 800°C, vorzugsweise in einem Bereich von 300 °C bis 800 C. Die Temperatur der zu beschichtenden Oberfläche kann auch in einem Bereich von Raumtemperatur bis 800°C liegen. Die Abscheidung der Schicht findet vorzugsweise bei Atmosphärendruck (auch Normaldruck genannt) statt. Normaldruckplasmaverfahren erfordern einen wesentlich geringeren technischen Aufwand, da eine Behandlung der zu beschichtenden Oberfläche im Vakuum entfällt. Beim Normaldruckplasmaverfahren bilden sich die Partikel im Plasmastrom. Die Größe der Agglomerate aus diesen Partikeln und somit wesentliche Eigenschaften der Beschichtung lassen sich unter anderem durch den Abstand der Plasmaquelle von der Oberfläche einstellen. Die Homogenität der abgeschiedenen Schichten ist mit den durch Beflammung erzielten vergleichbar, der erforderliche Energieeintrag ist jedoch wesentlich geringer. Alternativ kann das Verfahren auch bei leicht reduziertem Normaldruck durchgeführt werden.

Die Erzeugung des Plasmas erfolgt erfindungsgemäß in einer Freistrahlplasmaquelle. Bei diesem Verfahren wird eine Hochfrequenzentladung, erfindungsgemäß mit einer Frequenz von 20 kHz bis 50 kHz, zwischen zwei konzentrischen Elektroden gezündet, wobei durch einen angelegten Gasstrom das sich bildende Hohlkathodenplasma als Plasmajet aus der Elektrodenanordnung in aller Regel mehrere Zentimeter in den freien Raum und zur zu beschichtenden Oberfläche herausgeführt wird. Der Precursor kann sowohl vor der Anregung in das Arbeitsgas (direct plasma processing) als auch danach in das bereits gebildete Plasma oder in dessen Nähe (remote plasma processing) eingeleitet werden. Erfindungsgemäß wird als Arbeitsgas Luft verwendet.

Eine weitere, nicht erfindungsgemäße Möglichkeit der Plasmaerzeugung ist das Ausnutzen einer dielektrisch behinderten Entladung. Dabei wird das als Dielektrikum dienende Arbeitsgas, insbesondere Luft, zwischen zwei Elektroden hindurchgeleitet. Die Plasmaentladung erfolgt zwischen den Elektroden, welche mit hochfrequenter Hochspannung gespeist werden. Ebenso kann das Glassubstrat selbst als Dielektrikum genutzt werden, indem der Gasstrom zwischen einer metallischen Flächenelektrode und dem flachen Gassubstrat hindurch geführt wird.

Der Precursor wird vorzugsweise im gasförmigen Zustand in das Arbeitsgas oder den Plasmastrom eingeleitet. Flüssige oder feste, insbesondere pulverförmige Precursoren sind ebenfalls einsetzbar, werden jedoch bevorzugt vor der Einleitung, beispielsweise durch Verdampfung, in den gasförmigen Zustand überführt. Ebenso kann der Precursor zunächst in ein Trägergas eingeleitet, davon mitgerissen und zusammen mit diesem in das Arbeitsgas oder den Plasmastrom eingeleitet werden.

Der Durchsatz des Arbeitsgases und/oder des Precursors ist vorzugsweise variabel und steuerbar und/oder regelbar. Insbesondere sind die Durchsätze von Arbeitsgas und Precursor unabhängig voneinander steuerbar und/oder regelbar. Neben dem Abstand der Plasmaquelle zu der zu beschichtenden Oberfläche steht so ein weiteres Mittel zur Beeinflussung der Schichteigenschaften, wie beispielsweise der Schichtdicke oder der Brechzahl, zur Verfügung. Ebenso sind auf diese Weise Gradientenschichten realisierbar. Durch geeignete Wahl dieser Prozessparameter und der verwendeten Precursoren sind beispielsweise folgende Eigenschaften des Substrats gezielt veränderbar: Kratzfestigkeit, Selbstheilungsfähigkeit, Barriereverhalten, Reflexionsverhalten, Transmissionsverhalten, Brechungsindex, Transparenz, Lichtstreuung, elektrische Leitfähigkeit, antibakterielles Verhalten, Reibung, Haftung, Hydrophilie, Hydrophobie, Oleophobie, Oberflächenspannung, Oberflächenenergie, antikorrosive Wirkung, schmutzabweisende Wirkung, Selbstreinigungsfähigkeit, photokatalytisches Verhalten, Antistressverhalten, Verschleißverhalten, chemische Widerstandsfähigkeit, biozides Verhalten, biokompatibles Verhalten, elektrostatisches Verhalten, elektrochrome Aktivität, photochrome Aktivität, gasochrome Aktivität.

Die abgeschiedene Schicht umfasst vorzugsweise mindestens eine der Komponenten Silizium, Silber, Gold, Kupfer, Eisen, Nickel, Kobalt, Selen, Zinn, Aluminium, Titan, Zink, Zirkon, Tantal, Chrom, Mangan, Molybdän, Wolfram, Wismut, Germanium, Niob, Vanadium, Gallium, Indium, Magnesium, Calzium, Strontium, Barium, Lithium, Lanthanide, Kohlenstoff, Sauerstoff, Stickstoff, Schwefel, Bor, Phosphor, Fluor, Halogene und Wasserstoff. Insbesondere enthalten die Schichten oxidische oder/und nitridische Verbindungen von Silizium, Titan, Zinn, Aluminium, Zink, Wolfram und Zirkon.

Als Precursor wird bevorzugt eine Siliziumorganische Verbindung oder eine Silizium- und titanorganische Verbindung verwendet, beispielsweise Hexamethyldisioxan, Tetramethylsilan, Tetramethoxysilan, Tetraethoxysilan, Titantetraisopropylat oder Titantetraisobutylat.

Auf diese Weise sind beispielsweise Barriereschichten realisierbar, die die Durchlässigkeit für Gase und Wasser verringern.

In einer bevorzugten Ausführungsform wird eine erste Schicht mit einer Barrierewirkung und anschließend mindestens eine weitere Schicht als Funktionsschicht, vorzugsweise mit mindestens einer der oben genannten Eigenschaften auf einem Kalk-Natrium-Silikatglas (Standard-Floatglas) abgeschieden. Die Barriereschicht verringert zum einen den Durchtritt von Wasser, Kohlendioxid und anderen Substanzen aus der Atmosphäre zur Oberfläche des Glassubstrats. Andererseits wird eine Migration insbesondere von Natrium aus dem Glas in die Funktionsschicht verringert, so dass deren Aktivität erhalten bleibt. Die Funktionsschicht kann dabei mittels des gleichen Verfahrens oder mittels eines anderen Beschichtungsverfahrens auf dem noch heißen oder bereits abgekühlten Glas aufgebracht werden.

Ausführungsbeispiele der Erfindung werden im Folgenden anhand von Zeichnungen näher erläutert.

Darin zeigen:
- Fig. 1: Transmissionsspektren eines Glassubstrats in unbehandeltem Zustand, mit einem Atmosphärendruckplasma behandelt und mit einem Atmosphärendruckplasma beschichtet,
- Fig. 2: Transmissionsspektren von Substraten aus Flachglas in unbehandeltem Zustand und mittels einer Freistrahlplasmaquelle bei Atmosphärendruck mit Schichten verschiedener Schichtdicke beschichtet,
- Fig. 3: Transmissionsspektren von Substraten aus Flachglas in unbehandeltem Zustand und mittels einer in einer Plasmaquelle erzeugten Blascorona bei Atmosphärendruck mit Schichten verschiedener Schichtdicke beschichtet,
- Fig. 4: Transmissionsspektren von Substraten aus Polycarbonat in unbehandeltem Zustand und mittels einer Blascoronaplasmaquelle bei Atmosphärendruck mit Schichten verschiedener Schichtdicke beschichtet, und
- Fig. 5: Transmissionsspektren von Substraten aus Flachglas in unbehandeltem Zustand und mittels eines durch dielektrisch behinderte Entladung erzeugten Plasmas bei Atmosphärendruck mit Schichten verschiedener Schichtdicke beschichtet.

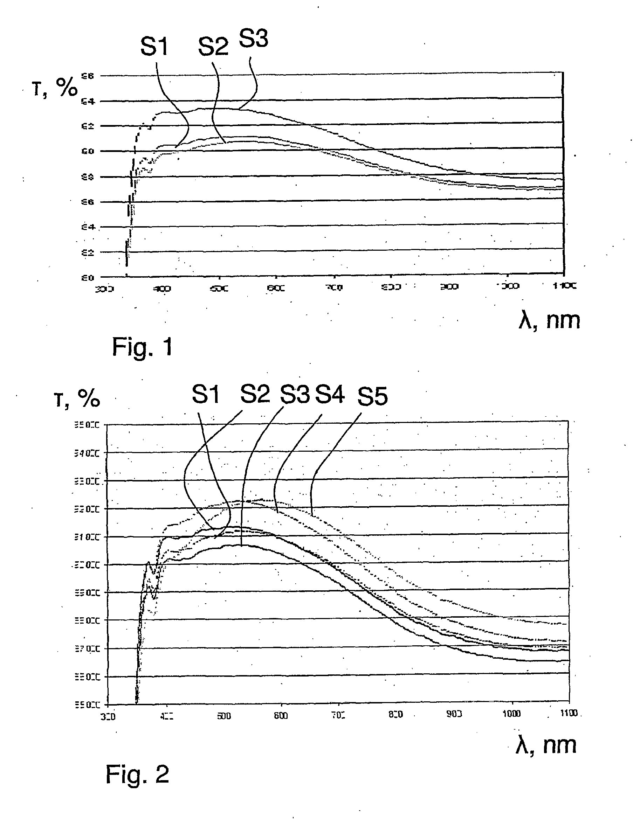

**Figur 1** zeigt Transmissionsspektren eines Glassubstrats. Ein Substrat aus Floatglas wird mittels eines Atmosphärendruck-Plasmabrenners beschichtet. In einer als Hohlkatode ausgeführten Düse wird mittels Hochfrequenz- Hochspannungsentladung ein Plasma generiert und durch einen Luftgasstrom, welcher durch die Düse geführt wird, aus derselben in einem zwei bis drei Zentimeter langen Plasmastrahl herausgeführt. Für den Betrieb wird der Hohlkatode eine Hochspannung von etwa 15 kV bei einer Frequenz von 20 kHz bis 50 kHz zugeführt. Die elektrische Leistung dieser Anordnung beträgt beispielsweise etwa 200 W. Der Gasvordruck des Luftgasstroms liegt bei etwa 5 bar. Wird dieser Luftgasstrom mit einem oder mehreren Precursoren angereichert, können mit einer derartigen Anordnung dünne Schichten auf Substraten, welche sich in einem gewissen Abstand zum Atmosphärendruck-Plasmabrenner befinden, abgeschieden werden. Als Substrat werden Flachglas-Objektträger verwendet, deren Oberfläche mittels einer herkömmlichen Heizplatte auf etwa 550 °C erwärmt wird. Die Proben werden mit Hilfe eines x-y-Verfahrtisches unter der nach unten gerichteten Düse des Atmosphärendruck-Plasmabrenners hindurchgeführt. Der Abstand der Düse zum Substrat beträgt 10 mm. Die Verfahrgeschwindigkeit liegt bei 150 mm/sec bei einem Rasterabstand von 2 mm. Insgesamt werden vier Durchläufe realisiert. In den Luftgasstrom wird ein Precursor mit einem Durchsatz von 0,5 1/min eindosiert. Dabei wird auf der Oberfläche des Substrats eine Schicht abgeschieden. Die abgeschiedene Schicht weist folgende Eigenschaften auf:
Dicke: ca. 190nm
Brechungsindex: ca. *n* = 1,47

Figur 1 zeigt die Transmissionsspektren von verschiedenen Objektträgern. Dabei ist eine Transmission τ über einer Wellenlänge λ abgebildet. Das Transmissionsspektrum S1 charakterisiert eine unbeschichtete Oberfläche des Substrats. Das Transmissionsspektrum S2 ist charakteristisch für ein mit oben genannten Parametern, jedoch ohne Zugabe von Precursor behandeltes Substrat. Das Transmissionsspektrum S3 zeigt Charakteristika eines mit den genannten Parametern einschließlich Zugabe von Precursor behandelten und beschichteten Substrats. Aus der Figur wird deutlich, dass die Transmission τ des beschichteten Substrats gegenüber dem unbeschichteten Substrat und dem lediglich mit dem Plasma behandelten Substrat deutlich verbessert ist, so dass sich eine Antireflexwirkung ergibt.

**Figur 2** zeigt Transmissionsspektren von Substraten aus Flachglas. Ein Substrat aus Floatglas wird mittels eines Freistrahl-Plasmabrenners unter Atmosphärendruck beschichtet. In einer als Hohlkatode ausgeführten Düse wird mittels Hochfrequenz-Hochspannungsentladung ein Plasma generiert und durch einen Luftgasstrom, welcher durch die Düse geführt wird, aus derselben in einem zwei bis drei Zentimeter langen Plasmastrahl herausgeführt. Für den Betrieb wird der Hohlkatode eine Hochspannung von etwa 15 kV bei einer Frequenz von 20 kHz bis 50 kHz zugeführt. Die elektrische Leistung dieser Anordnung beträgt beispielsweise etwa 200 W. Der Gasvordruck des Luftgasstroms liegt bei etwa 5 bar. Wird dieser Luftgasstrom mit einem oder mehreren Precursoren angereichert, können mit einer derartigen Anordnung dünne Schichten auf Substraten, welche sich in einem gewissen Abstand zum Freistrahl-Plasmabrenner befinden, abgeschieden werden. Als Substrat werden Flachglas-Objektträger verwendet. Ebenso können beispielsweise Polycarbonat- oder Siliziumscheiben beschichtet werden. Die Proben werden mit Hilfe eines x-y-Verfahrtisches unter der nach unten gerichteten Düse des Freistrahl-Plasmabrenners hindurchgeführt. Der Abstand der Düse zum Substrat beträgt 10 mm. Die Verfahrgeschwindigkeit liegt bei 150 mm/sec bei einem Rasterabstand von 2 mm. Insgesamt werden zwei Durchläufe realisiert. In den Luftgasstrom wird ein Precursor mit einem Durchsatz von 0 bis 0,5 l/min eindosiert. Dabei wird auf der Oberfläche des Substrats eine Schicht abgeschieden, deren Schichtdicke vom Durchsatz abhängt. Als Precursor wurde Hexamethlydisiloxan verwendet. Die abgeschiedenen Schichten enthalten dementsprechend im Wesentlichen Siliziumoxid.

Figur 2 zeigt die Transmissionsspektren von verschiedenen Substraten. Dabei ist eine Transmission τ über einer Wellenlänge λ abgebildet. Das Transmissionsspektrum S1 charakterisiert eine unbeschichtete Oberfläche des Substrats. Die Transmissionsspektren S2, S3, S4, S5 zeigen Charakteristika von Substraten mit Schichten mit einer Schichtdicke von jeweils: 68,5 nm, 69,5 nm, 90 nm und 126 nm, die mit dem beschriebenen Verfahren abgeschieden wurden. Aus der Figur wird deutlich, dass die Transmission τ der durch die Transmissionsspektren S2, S4, S5 charakterisierten beschichteten Substrate gegenüber dem unbeschichteten Substrat bei einer Wellenlänge λ von ca. 550 nm deutlich verbessert ist.

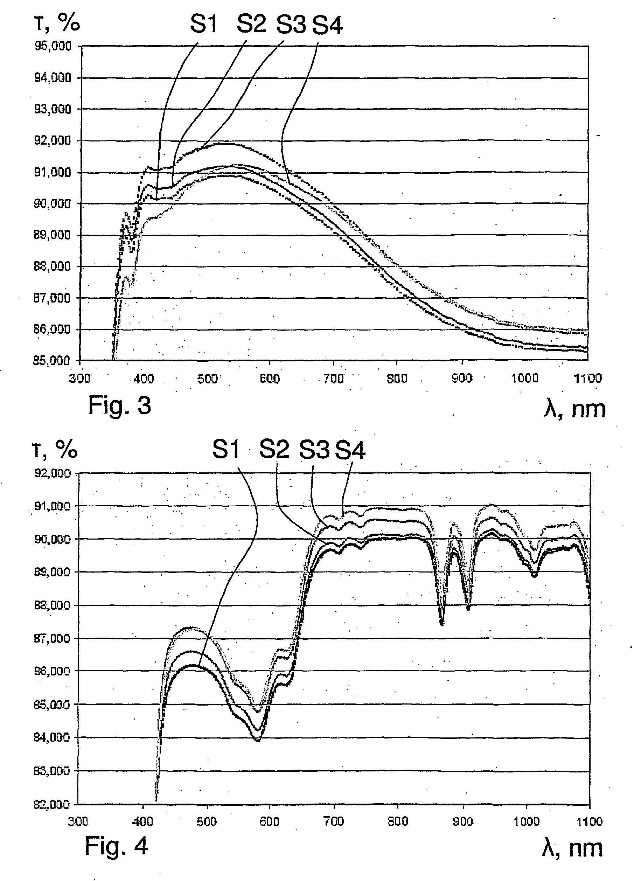

**Figur 3** zeigt Transmissionsspektren von Substraten aus Flachglas. In einem nicht erfindungsgemäßen Verfahren wird ein Substrat aus Floatglas mittels eines Plasmabrenners unter Atmosphärendruck beschichtet. Das Plasma wird dabei in einem Elektrodenkopf zwischen zwei Hochspannungselektroden mittels dielektrisch behinderter Entladung erzeugt. Der Abstand zwischen den Hochspannungselektroden beträgt etwa 10 mm. Als Dielektrikum und Arbeitsgas dient Druckluft, welche mittels eines Lüfters bereitgestellt und zwischen den Elektroden heraus geblasen wird. Die dabei entstehenden Sprühentladungen werden mit dem Arbeitsgas aus dem Elektrodenkopf herausgeführt. Die Arbeitsbreite des Elektrodenkopfes beträgt 60 mm, die Elektroden werden mit Hochspannung bei einer Frequenz von 20 kHz versorgt. Als Substrat wird beispielsweise 3 mm dickes Flachglas verwendet. Ebenso kann beispielsweise Polycarbonat beschichtet werden. Die Proben werden mit Hilfe eines x-y-Verfahrtisches unter dem Elektrodenkopf des Plasmabrenners hindurchgeführt. Der Abstand der Düse zum Substrat beträgt etwa 20 mm. Die Verfahrgeschwindigkeit liegt bei 150 mm/sec. Es wird eine unterschiedlich große Anzahl Durchläufe realisiert, wobei sich Schichten verschiedener Schichtdicken ergeben. In den Luftgasstrom wird als Precursor Hexamethyldisiloxan mit einem Durchsatz von 2 l/min eindosiert. Die abgeschiedenen Schichten enthalten dementsprechend im Wesentlichen Siliziumoxid.

Figur 3 zeigt die Transmissionsspektren von verschiedenen Substraten. Dabei ist eine Transmission τ über einer Wellenlänge λ abgebildet. Das Transmissionsspektrum S 1 charakterisiert eine unbeschichtete Oberfläche des Substrats. Die Transmissionsspektren S2, S3, S4 zeigen Charakteristika von Substraten mit Schichten mit einer Schichtdicke von jeweils: 47 nm, 77 nm und 90 nm, die mit dem beschriebenen Verfahren abgeschieden wurden. Aus der Figur wird deutlich, dass die Transmission τ der durch die Transmissionsspektren S2, S3, S4 charakterisierten beschichteten Substrate gegenüber dem unbeschichteten Substrat bei einer Wellenlänge λ von ca. 550 nm deutlich verbessert ist.

**Figur 4** zeigt Transmissionsspektren von Substraten aus Polycarbonat, die mit dem für Figur 3 beschriebenen, nicht erfindungsgemäßen Verfahren beschichtet wurden. Das Transmissionsspektrum S1 charakterisiert eine unbeschichtete Oberfläche des Substrats. Die Transmissionsspektren S2, S3, S4 zeigen Charakteristika von Substraten mit Schichten mit einer Schichtdicke von jeweils: 18 nm, 32 nm und 42 nm, die mit dem beschriebenen Verfahren abgeschieden wurden. Aus der Figur wird deutlich, dass die Transmission τ der durch die Transmissionsspektren S2, S3, S4 charakterisierten beschichteten Substrate gegenüber dem unbeschichteten Substrat bei einer Wellenlänge λ von ca. 550 nm deutlich verbessert ist.

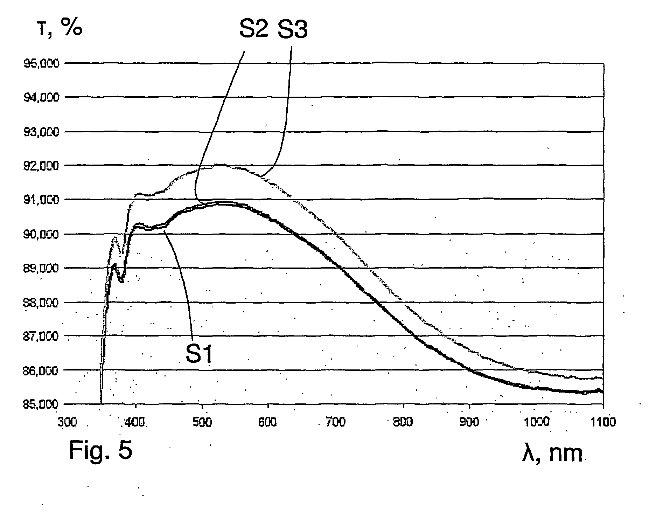

**Figur 5** zeigt Transmissionsspektren von Substraten aus Flachglas. In einem nicht erfindungsgemäßen Verfahren wird ein Substrat aus Floatglas mittels eines Plasmabrenners unter Atmosphärendruck beschichtet. Das Plasma wird dabei mittels dielektrisch behinderter Entladung zwischen zwei horizontal angeordneten, etwa 5 cm x 10 cm großen planaren Hochspannungselektroden erzeugt. Eine der beiden Hochspannungselektroden, beispielsweise die obere, ist mit einer isolierenden, etwa 1 mm dicken Keramikplatte, welche als Dielektrikum dient, verklebt. Zwischen der oberen Hochspannungselektrode, welche mit einer hochfrequenten Hochspannung versorgt wird, und der unteren, auf Masse liegenden bzw. geerdeten Hochspannungselektrode, befindet sich ein Luftspalt, welcher wenige Millimeter dick sein kann. In diesem Zwischenraum bildet sich nach Anlegen der Spannung ein flächiges Plasma aus, das aus vielen kleinen Entladungskanälen gebildet wird. Die Hochspannungselektrode beinhaltet ein Gaszuleitungssystem, durch welches ein precursorhaltiges Arbeitsgas durch einen Schlitz in der Keramikplatte dem Plasmaraum zugeführt werden kann. Bildet man in der unteren Hochspannungselektrode eine Ausformung zur Aufnahme von planaren Substraten, wie zum Beispiel Flachglas aus, so kann man auf diese Weise Beschichtungen auf planaren Substraten herstellen. Zu diesem Zweck kann man die untere Hochspannungselektrode auf einer x-y-Verschiebeeinheit montieren, welche sich im geeigneten Abstand zur oberen Hochspannungselektrode befindet. Durch Hin- und Herfahren der mit dem Substrat versehenen unteren Hochspannungselektrode unterhalb der oberen Hochspannungselektrode kommt es bei deren Passieren zur Ausbildung der dielektrisch behinderten Entladung und zur Umsetzung des ständig zur Verfügung gestellten precursorhaltigen Gases.

Als Substrat wird beispielsweise 3 mm dickes Flachglas verwendet. Die Proben werden mit Hilfe eines x-y-Verfahrtisches unter der oberen Hochspannungselektrode hindurchgeführt. Der Abstand der oberen Hochspannungselektrode zum Substrat beträgt etwa 1 mm. Die Verfahrgeschwindigkeit liegt bei 60 mm/sec. Es werden 20 Durchläufe realisiert. Verschiedene Schichtdicken wurden durch eine Variation des Durchsatzes des precursorhaltigen Gases zwischen 0 und 0,4 l/min erzielt. Als Precursor wurde Hexamethlydisiloxan verwendet. Die abgeschiedenen Schichten enthalten dementsprechend im Wesentlichen Siliziumoxid.

Figur 5 zeigt die Transmissionsspektren von verschiedenen Substraten. Dabei ist eine Transmission τ über einer Wellenlänge λ abgebildet. Das Transmissionsspektrum S 1 charakterisiert eine unbeschichtete Oberfläche des Substrats. Die Transmissionsspektren S2, S3 zeigen Charakteristika von Substraten mit Schichten mit einer Schichtdicke von jeweils: 15 nm und 76 nm, die mit dem beschriebenen Verfahren abgeschieden wurden. Aus der Figur wird deutlich, dass die Transmission τ des durch das Transmissionsspektrum S3 charakterisierten beschichteten Substrats gegenüber dem unbeschichteten Substrat bei einer Wellenlänge λ von ca. 550 nm deutlich verbessert ist.

Die genannten Parameter sind exemplarisch und nicht einschränkend zu verstehen.

Als Substrat können andere Materialien, insbesondere Kunststoff, Keramik, Glaskeramik oder Metalle verwendet werden. Ebenso kann die Beschichtung auf einem bereits beschichteten Substrat stattfinden.

Der Beschichtungsvorgang kann im Anschluss an einen Herstellungsprozess des Substrats auf der noch heißen Oberfläche des Substrats durchgeführt werden. Bei einem in einer Floatwanne hergestelltem Glassubstrat kann dessen Beschichtung unmittelbar im Anschluss stattfinden.

Die Temperatur der Oberfläche liegt in einem Bereich von 100 °C bis 800°C, insbesondere in einem Bereich von 300 °C bis 800 °C. Es ist alternativ auch möglich, das Verfahren anzuwenden, wenn die Temperatur der Oberfläche in einem Bereich von Raumtemperatur bis 800°C oder, insbesondere bei der Verwendung von Substraten aus Kunststoff, in einem Bereich von Raumtemperatur bis 100 °C oder 200 °C liegt.

Das Verfahren wird bei Druckverhältnissen durchgeführt, welche sich aus dem umgebenden atmosphärischen Druck und den von der Anlage erzeugten Strömungsverhältnissen, insbesondere des Trägergasstromes und der Abgasabfuhr, ergeben.

Das Verfahren wird vorzugsweise bei einem Druck größer als 800 mbar, insbesondere bei Atmosphärendruck, durchgeführt.

Zur Erzeugung des Plasmas kommt erfindungsgemäß eine Freistrahlplasmaquelle zur Anwendung.

Der Precursor wird vorzugsweise gasförmig in das Arbeitsgas oder in das Plasma eingebracht. Ist der Precursor flüssig oder fest, wird er bevorzugt vor dem Einleiten in das Arbeitsgas oder in den Plasmastrahl in den gasförmigen Zustand überführt.

Der Durchsatz des Arbeitsgases und/oder des Precursors ist variabel und steuerbar und/oder regelbar. Insbesondere sind die Durchsätze des Arbeitsgases und des Precursors unabhängig voneinander steuerbar und/oder regelbar. Auf diese Weise kann eine Schicht als Gradientenschicht abgeschieden werden.

Alternativ oder zusätzlich zu einer transmissionsverbessernden Schicht können abgeschiedene Schichten auch folgende Eigenschaften des Substrats verändern: Kratzfestigkeit, Selbstheilungsfähigkeit, Barriereverhalten, Brechungsindex, Transparenz, Lichtstreuung, elektrische Leitfähigkeit, antibakterielles Verhalten, Reibung, Haftung, Hydrophilie, Hydrophobie, Oleophobie, Oberflächenspannung, Oberflächenenergie, antikorrosive Wirkung, schmutzabweisende Wirkung, Selbstreinigungsfähigkeit, photokatalytisches Verhalten, Antistressverhalten, Verschleißverhalten, chemische Widerstandsfähigkeit, biozides Verhalten, biokompatibles Verhalten, elektrostatisches Verhalten, elektrochrome Aktivität, photochrome Aktivität, gasochrome Aktivität und gasochrome Aktivität.

Die Precursoren werden insbesondere so gewählt, dass die abgeschiedene Schicht mindestens eine der Komponenten Silizium, Silber, Gold, Kupfer, Eisen, Nickel, Kobalt, Selen, Zinn, Aluminium, Titan, Zink, Zirkon, Tantal, Chrom, Mangan, Molybdän, Wolfram, Wismut, Germanium, Niob, Vanadium, Gallium, Indium, Magnesium, Calzium, Strontium, Barium, Lithium, Lanthanide, Kohlenstoff, Sauerstoff, Stickstoff, Schwefel, Bor, Phosphor, Fluor, Halogene und Wasserstoff enthält.

Besonders bevorzugt werden als Precursor siliziumorganische und/oder titanorganische Verbindungen verwendet.

Als Arbeitsgas wird erfindungsgemäß Luft verwendet.

Es können mehrere Schichten nacheinander abgeschieden werden. Beispielsweise kann eine erste Schicht mit einer Barrierewirkung und anschließend eine weitere Schicht abgeschieden werden.

Die in den Ausführungsbeispielen dargestellten Verfahren sehen eine Beschichtung von oben vor. Die Beschichtung kann jedoch auch von unten oder bei vertikal bzw. geneigt ausgerichtetem Substrat von der Seite erfolgen. Insbesondere ist eine Beschichtung auch von mehreren Seiten gleichzeitig möglich, bei einem planaren Substrat beispielsweise von oben und unten.

### BEZUGSZEICHENLISTE

- S1, S2, S3, S4, S5: Transmissionsspektren
- λ: Wellenlänge
- τ: Transmission

## Patentansprüche

1. Verfahren zum Beschichten eines Substrats, bei dem aus einem Arbeitsgas ein Plasmastrahl erzeugt wird, bei dem mindestens ein Precursormaterial dem Arbeitsgas und/oder dem Plasmastrahl zugeführt und im Plasmastrahl zur Reaktion gebracht wird und bei dem mindestens ein Reaktionsprodukt mindestens eines der Precursoren auf mindestens einer Oberfläche des Substrats und/oder auf mindestens einer auf der Oberfläche angeordneten Schicht abgeschieden wird, wobei in mindestens einer der Schichten Siliziumoxid zur Verbesserung der optischen Transmission und/oder zur Verringerung der Reflexion des Substrats abgeschieden wird, wobei das Substrat zumindest für eine erste Beschichtung heiß ist oder erhitzt wird, wobei die erste Beschichtung im Anschluss an einen Herstellungsprozess des Substrats stattfindet, bei dem das Substrat mit Hilfe von Wärme gebildet wird,
**dadurch gekennzeichnet, dass** die Erzeugung des Plasmas in einer Freistrahlplasmaquelle erfolgt, derart, dass eine Hochfrequenzentladung mit einer Frequenz von 20 kHz bis 50 kHz zwischen zwei konzentrischen Elektroden gezündet wird, wobei durch einen angelegten Arbeitsgasstrom ein sich bildendes Hohlkathodenplasma als Plasmajet aus der Elektrodenanordnung in den freien Raum und zur zu beschichtenden Oberfläche herausgeführt wird, wobei als Arbeitsgas Luft verwendet wird.

2. Verfahren nach Anspruch 1, **gekennzeichnet durch** die Beschichtung eines Substrats aus einem der Stoffe Glas, Kunststoff, Glaskeramik, Keramik und Metall.

3. Verfahren nach einem der Ansprüche 1 oder 2, **dadurch gekennzeichnet, dass** eine Temperatur des Substrats zumindest an einer Substratoberfläche in einem Bereich von 300 °C bis 800 °C liegt.

4. Verfahren nach einem der Ansprüche 1 bis 3, **dadurch gekennzeichnet, dass** die Abscheidung der Schicht bei einem Druck erfolgt, der sich aus dem umgebenden atmosphärischen Druck und den in der Anlage herrschenden Strömungsverhältnissen ergibt..

5. Verfahren nach Anspruch 4, **dadurch gekennzeichnet, dass** die Abscheidung der Schicht bei Atmosphärendruck erfolgt.

6. Verfahren nach einem der Ansprüche 1 bis 5, **dadurch gekennzeichnet, dass** ein gasförmiger Precursor verwendet wird.

7. Verfahren nach einem der Ansprüche 1 bis 6, **dadurch gekennzeichnet, dass** die abgeschiedene Schicht mindestens eine der Komponenten Silizium, Silber, Gold, Kupfer, Eisen, Nickel, Kobalt, Selen, Zinn, Aluminium, Titan, Zink, Zirkon, Tantal, Chrom, Mangan, Molybdän, Wolfram, Wismut, Germanium, Niob, Vanadium, Gallium, Indium, Magnesium, Calzium, Strontium, Barium, Lithium, Lanthanide, Kohlenstoff, Sauerstoff, Stickstoff, Schwefel, Bor, Phosphor, Fluor, Halogene und Wasserstoff enthält.

8. Verfahren nach einem der Ansprüche 1 bis 7, **dadurch gekennzeichnet, dass** als Precursor eine Silizium- organische Verbindung oder eine Silizium- und titanorganische Verbindung verwendet wird.

9. Verfahren nach einem der Ansprüche 1 bis 8, **dadurch gekennzeichnet, dass** mindestens eine der Schichten als Gradientenschicht abgeschieden wird.

10. Verfahren nach einem der Ansprüche 1 bis 9, **dadurch gekennzeichnet, dass** eine erste Schicht mit einer Barrierewirkung und anschließend mindestens eine weitere Schicht abgeschieden wird.

11. Verfahren nach einem der Ansprüche 1 oder 2, **dadurch gekennzeichnet, dass** eine Temperatur des Substrats zumindest an einer Substratoberfläche in einem Bereich von Raumtemperatur bis 800°C liegt.

## Claims

1. Process for coating a substrate, in which a plasma jet is produced from a working gas, at least one precursor material is introduced into the working gas and/or the plasma jet and is reacted in the plasma jet and at least one reaction product of at least one of the precursors is deposited on at least one surface of the substrate and/or on at least one layer arranged on the surface, where silicon oxide is deposited in at least one of the layers in order to improve the optical transmission and/or to reduce the reflection of the substrate, where the substrate is hot or is heated at least for a first coating step, where the first coating step takes place after a production process for the substrate in which the substrate is formed with the aid of heat, **characterized in that** the production of the plasma is effected in a free jet plasma source in such a way that a high-frequency discharge having a frequency of from 20 kHz to 50 kHz is ignited between two concentric electrodes, where a hollow cathode plasma being formed is ejected as plasma jet from the electrode arrangement into the free space by means of an introduced working gas stream and conveyed to the surface to be coated, with air being used as working gas.

2. Process according to Claim 1, **characterized by** the coating of a substrate composed of one of the materials glass, plastic, glass-ceramic, ceramic and metal.

3. Process according to either Claim 1 or 2, **characterized in that** a temperature of the substrate in a range from 300°C to 800°C prevails on at least one substrate surface.

4. Process according to any of Claims 1 to 3, **characterized in that** the deposition of the layer is carried out at a pressure made up of the ambient atmospheric pressure and the flow conditions prevailing in the plant.

5. Process according to Claim 4, **characterized in that** the deposition of the layer is carried out at atmospheric pressure.

6. Process according to any of Claims 1 to 5, **characterized in that** a gaseous precursor is used.

7. Process according to any of Claims 1 to 6, **characterized in that** the deposited layer contains at least one of the components silicon, silver, gold, copper, iron, nickel, cobalt, selenium, tin, aluminium, titanium, zinc, zirconium, tantalum, chromium, manganese, molybdenum, tungsten, bismuth, germanium, niobium, vanadium, gallium, indium, magnesium, calcium, strontium, barium, lithium, lanthanides, carbon, oxygen, nitrogen, sulphur, boron, phosphorus, fluorine, halogens and hydrogen.

8. Process according to any of Claims 1 to 7, **characterized in that** a silicon-organic compound or a silicon- and titanium-organic compound is used as precursor.

9. Process according to any of Claims 1 to 8, **characterized in that** at least one of the layers is deposited as gradient layer.

10. Process according to any of Claims 1 to 9, **characterized in that** a first layer having a barrier action and subsequently at least one further layer are deposited.

11. Process according to either Claim 1 or 2, **characterized in that** a temperature of the substrate in a range from room temperature to 800°C prevails on at least one substrate surface.

## Revendications

1. Procédé de revêtement d'un substrat dans lequel un faisceau de plasma est formé à partir d'un gaz de travail, au moins un matériau précurseur est ajouté au gaz de travail et/ou au faisceau plasma et est amené à réagir dans le faisceau plasma et au moins un produit de réaction d'au moins un des précurseurs est déposé sur au moins une surface du substrat et/ou sur au moins une couche disposée sur la surface, de l'oxyde de silicium est déposé dans au moins l'une des couches, pour améliorer la transmission optique et/ou pour diminuer la réflexion du substrat, le substrat est chaud ou chauffé au moins pour un premier revêtement, le premier revêtement a lieu après une opération de fabrication du substrat dans laquelle le substrat est formé à l'aide de chaleur, **caractérisé en ce que** la formation du plasma a lieu dans une source de plasma à faisceau libre en allumant une charge entre deux électrodes concentriques à une haute fréquence comprise entre 20 kHz et 50 kHz, **en ce que** l'écoulement de gaz de travail appliqué forme un plasma à cathode creuse en tant que plasma projeté par l'ensemble d'électrodes dans l'espace libre et en direction de la surface à revêtir et **en ce que** l'air est utilisé comme gaz de travail.

2. Procédé selon la revendication 1, **caractérisé par** le revêtement d'un substrat constitué d'une des matières que sont le verre, les matières synthétiques, la vitrocéramique, la céramique et les métaux.

3. Procédé selon l'une des revendications 1 ou 2, **caractérisé en ce qu'**au moins sur une surface du substrat, la température du substrat est située dans la plage de 300°C à 800°C.

4. Procédé selon l'une des revendications 1 à 3, **caractérisé en ce que** le dépôt de la couche s'effectue à une pression qui résulte de la pression atmosphérique ambiante et des conditions d'écoulement qui règnent dans l'installation.

5. Procédé selon la revendication 4, **caractérisé en ce que** le dépôt de la couche s'effectue à pression atmosphérique.

6. Procédé selon l'une des revendications 1 à 5, **caractérisé en ce qu'**il utilise un précurseur gazeux.

7. Procédé selon l'une des revendications 1 à 6, **caractérisé en ce que** la couche déposée contient au moins l'un des composants silicium, argent, or, cuivre, fer, nickel, cobalt, sélénium, étain, aluminium, titane, zinc, zirconium, tantale, chrome, manganèse, molybdène, tungstène, bismuth, germanium, niobium, vanadium, gallium, indium, magnésium, calcium, strontium, baryum, lithium, lanthanides, carbone, oxygène, azote, soufre, bore, phosphore, fluor, halogènes et hydrogène.

8. Procédé selon l'une des revendications 1 à 7, **caractérisé en ce que** le précurseur utilisé est un composé organique du silicium ou un composé organique du silicium et du titane.

9. Procédé selon l'une des revendications 1 à 8, **caractérisé en ce qu'**au moins l'une des couches est déposée en tant que couche à gradient.

10. Procédé selon l'une des revendications 1 à 9, **caractérisé en ce qu'**une première couche à effet de barrière est déposée, avec ensuite au moins une autre couche.

11. Procédé selon l'une des revendications 1 ou 2, **caractérisé en ce que** la température du substrat est située dans la plage de la température ambiante à 800°C au moins sur une surface du substrat.
